(19) Europäisches Patentamt
European Patent Office
Office européen des brevets

(11) Publication number: **0 076 524**
**A1**

(12) # EUROPEAN PATENT APPLICATION

(21) Application number: 82109234.3

(51) Int. Cl.$^3$: **G 03 F 7/10**

(22) Date of filing: 06.10.82

(30) Priority: 06.10.81 JP 158203/81
06.10.81 JP 158204/81

(43) Date of publication of application:
13.04.83 Bulletin 83/15

(84) Designated Contracting States:
DE FR GB NL SE

(71) Applicant: TOKYO SHIBAURA DENKI KABUSHIKI KAISHA
72, Horikawa-cho Saiwai-ku
Kawasaki-shi Kanagawa-ken 210(JP)

(72) Inventor: Miura, Akira
4730, Ino
Toride-shi Ibarki-ken(JP)

(72) Inventor: Tada, Tsukasw
74, Sachigaoka Asahi-ku
Yokohama-shi Kanagawa-ken(JP)

(74) Representative: Hansen, Bernd, Dr.rer.nat. et al,
Hoffmann . Eitle & Partner Patentanwälte
Arabellastrasse 4
D-8000 München 81(DE)

(54) **Radiation-sensitive positive resist.**

(57) Disclosed is a radiation-sensitive positive resist represented by the following formula:

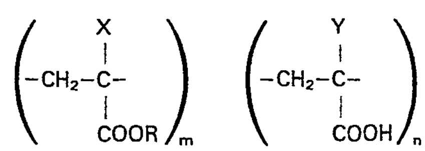

wherein X is a chlorine atom, a bromine atom or a fluorine atom; Y is a chlorine atom, a bromine atom, a fluorine atom or a methyl group; R is an alkyl group having 1 to 10 carbon atoms, at least one of the hydrogen of which alkyl group is substituted with a fluorine atom; and *m* and *n* are expressed in terms of mole % and are respectively 50 ≦ m ≦ and 99.5 and 0.5 ≦ n ≦ 50.

EP 0 076 524 A1

Radiation-sensitive positive resist

This invention relates to a radiation-sensitive positive resist suitable for use in the fabrication of photomask and semiconductor integrated circuit or the like having fine pattern dimentions. More specifically, this invention relates to a radiation sensitive positive resist of high sensitivity and resolution and excellent in adhesion to a substrate.

With a view to coping with recent trend toward the successful development of semiconductor devices and the like, it has been attempted to fabricate extremely fine patterns by mears of microlithographic technique employing higher energy radiations than ultraviolet rays which have heretofore been employed. Exemplary high energy radiations include electron beams, X-ray and ion beams.

Incidentally, it is necessary for resists useful in the practice of such lithographic technique to have such characteristics as high sensitivity and high resolution, in view of forming highly accurate circuit patterns with fast turnaround. Furthermore, high etch-resistance and good adhesion properties are also required as its characteristics, because each resist film should play significant role as a protective layer in such subsequent process as etching or the like. The latter

characteristics are particularly important from the practical resist viewpoint, since the delineated pattern accuity of such substrates as semiconductor integrated circuits and the like are profoundly affected by the adhesion properties of resists.

Many radiation-sensitive positive resists have heretofore been known. However, none of such known resists satisfy all the above-described characteristics. For example, poly(butene-1-sulfon) (PBS) is known as a representative of highly sensitive positive electron resist and is superior in resolution to negative resists. However, it is extremely inferior in such characteristics as etch-resistance and adhesion. In a dry etching step, it shows poor thermal stability and insufficient durability as a protective resist layer. On the other hand, in a wet chemical etching step, its adhesion to photomasks and semiconductor substrates are insufficient and the chemical etchant is thus caused to penetrate even into non-patterned regions, thereby making it difficult to form highly accurate circuit patterns.

The extent of adhesion between a resist and a substrate is generally evaluated by, upon, for example, processing the substrate in accordance with the wet chemical etching method, measuring the deviation of the fabricated substrate-patterns from the pre-determined resist patterns. Namely, in the case of good adhesion, the difference between the pattern widths of a circuit pattern formed on etched substrate and of the original resist pattern is extremely small. However, where resist shows poor adhesion to the substrate, the etchant penetrate even into undesired regions of the substrate, thereby causing "side-etching", say, a considerably

large deviation from the designed widths.

In recent years, halogen-containing positive resists having still higher sensitivity and resolution than such positive resists as the above-described PBS have been reported (U.S. Patent No. 4,259,407).

These resists are acrylate derivatives each having a fluorine-substituted ester moiety in a side chain and containing a fluorine or chlorine atom or the like at the α-position in its main chain. They can be used as radiation-sensitive positive resists.

However, many of these halogen-containing acrylate derivatives are water repellent and thus involve a problem with respect to their adhesion to photomask and semiconductor substrates. They also exhibit excellent resistance to an acidic chemical etchant. However, due to their water repellance and etch-tolerance to acidic etchant, they are accompanied with such inconvenience that the etching work is unavoidably non-uniform and incomplete.

Since these resists have high sensitivity, high resolution and good thermal stability, it appears to be more promissing for practical use of such resists for fabrication of microcircuit patterns provided that their adhesion problems are improved.

The adhesion of a resist is elucidated by the interaction between the resist and a substrate, namely, by its affinity (i.e., wettability) from surface chemical viewpoint.

Since the surface of a photomask or semiconductor

substrate is usually covered with ambient water molecules adsorbed thereon, hydroxyl groups, etc., it has an inherent low degree of affinity with a resist which is an hydrophobic organic-polymer. In order to improve the adhesion of a resist to substrate, it has heretofore been carried out to subject the substrate to a dewatering pretreatment by heating the substrate or to a surface treatment by applying an adhesion promoter such as silane-base coupling agent or the like onto the substrate. However, even after subjected to such a surface treatment as above, adhesion of resists of such halogen-containing acrylate derivatives as disclosed in the U.S. Patent No. 4,259,407 has not been improved to a noticeable extent. This failure appears to find its cause to the chemical compositions of such halogen-containing resists *per se*.

By the way, the concept of critical surface tension ($\gamma_C$) proposed by Zisman in "Advanced Chemical Series", 43, 1, (1964) has been preferably used to describe the extent of affinity (wettability) of the surface of a solid body. When applying the above concept to the adhesion aspect between a resist and substrate, corelation is recognized between the adhesive force of a resist (a polymer) and its critical surface tension ($\gamma_C$). Specifically speaking, $\gamma_C$ tends to increase as the adhesive force becomes greater. Furthermore, since there is a relation represented by $\cos\theta = 1 + b(\gamma_C - \gamma_L)$ in which $\theta$, $\gamma_L$ and b are the contact angle of each liquid, the surface tension of the liquid and a constant, respectively $\cos\theta$ increases, in other words, $\theta$ becomes smaller and the wettability becomes better as $\gamma_C$ goes up. Halogen, notably, fluorine-containing acrylate polymers generally have very small $\gamma_C$ values which range 10 to 25 dynes/cm. These values are very

small compared with the $\gamma_C$ value (about 36 dynes/cm) of polymethyl methacrylate (PMMA) which is commonly used as a positive resist.

The above-mentioned small $\gamma_C$ values of halogen-containing acrylates derivatives are considered to be closely related to their poor adhesion to substrates and also their poor hydrophilic nature.

Accordingly, it is not only necessary to modify the surface of each substrate but also important to change its corresponding resist *per se* in order to improve the adhesion between the substrate and resist.

The present inventors have carried out an intensive research with a view toward improving the adhesion and hydrophilic nature of certain halogen-containing acrylate derivatives, to substrates. As a result, they have come up with an idea that, since the surfaces of photomask and semiconductor substrates contain hydroxyl groups and are strongly acidic, the adhesion of such resists to substrates will be enhanced when such resists are rendered more basic and liable to form hydrogen bonds, leading to the development of resists according to this invention.

An object of this invention is thus to provide a radiation-sensitive positive resist having high sensitivity and resolution, excellent in adhesion to substrates, and effectively usable for the formation of microcircuit patterns.

According to this invention, there is thus provided a radiation-sensitive positive resist represented by the following formula:

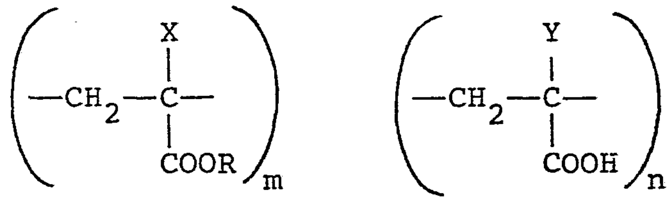

wherein X is a chlorine atom, a bromine atom or a fluorine atom; Y is a chlorine atom, a bromine atom, a fluorine atom or a methyl group; R is an alkyl group having 1 to 10 carbon atoms, at least one of the hydrogen of which alkyl group is substituted with a fluorine atom, and m and n are expressed in terms of mole % and are respectively $50 \leqq m \leqq 99.5$ and $0.5 \leqq n \leqq 50$.

Preferred examples of resists according to this invention may include trifluoroethyl-α-chloroacrylate/methacrylic acid copolymer, difluoropropyl-α-chloroacrylate/methacrylic acid copolymer, tetrafluoropropyl-α-chloroacrylate/methacrylic acid copolymer, octafluoropentyl-α-bromoacrylate/mechacrylic acid copolymer, trifluoroisopropyl-α-chloroacrylate/methacrylic acid copolymer, trifluoroisopropyl-α-fluoroacrylate/methacrylic acid copolymer, trifluorobutyl-α-chloroacrylate/methacrylic acid copolymer, trifluoroethyl-α-chloroacrylate/α-chloroacrylic acid copolymer, difluoropropyl-α-chloroacrylate/α-chloroacrylic acid copolymer, tetrafluoropropyl-α-chloroacrylate/α-chloroacrylic acid copolymer, octafluoropentyl-α-bromoacrylate/α-bromoacrylic acid copolymer, trifluoroisopropyl-α-fluoroacrylate/α-fluoroacrylic acid copolymer, trifluoro-t-butyl-α-chloroacrylate/α-chloroacrylic acid copolymer, trifluoro isopropyl-α-chloroacrylate/α-chloroacrylic acid copolymer.

The resists according to this invention may be readily

synthesized by polymerizing their corresponding monomers in accordance with the commonly employed radical polymerization method, or by hydrolyzing halogen-containing acrylate with use of a basic catalyst such for example as organic amines.

Here, the ratio of the acrylate moiety to the acid moiety in each copolymer (namely, m : n) is $50 \leqq m \leqq 99.5 : 0.5 \leqq n \leqq 50$ when expressed in terms of mole %. In view of the adequate solubility of a resist in a casting solvent and its effective adhesion to substrate, preferable ranges of m and n are respectively $80 \leqq m \leqq 99.5$ and $0.5 \leqq n \leqq 20$ when expressed in terms of mole %.

Formation of a microcircuit pattern using a resist according to this invention can be effected, for example, in the following manner.

First, the resist of this invention is dissolved in a solvent such as methyl cellosolve acetate, ethyl cellosolve acetate or methyl cellosolve to prepare a coating solution. The resultant solution is then coated by the spin-coating method on a photomask or semiconductor substrate, giving a thickness of 0.2 ∿ 2 µm. Thereafter, the resist layer is treated at temperature of from 150 to 200°C so as to drive off any remaining solvent.

Then, an externally controlled radiation such as electron beam or the like is irradiated onto the desired area of resist layer to form a latent image of a circuit pattern. The latent image is thereafter developed with a suitable solvent, thereby selectively removing unirradiated portions, and forming a desired

positive resist pattern on the substrate. Subsequently, using the delineated resist pattern as a protective layer, the photomask or semiconductor substrate, is subjected to a wet or dry etching treatment so as to form a microcircuit pattern corresponding to the positive resist pattern.

Advantage of a resist according to this invention will be more apparent from the following Examples.

Example 1

A resist coating solution was prepared by dissolving trifluoroethyl-α-chloroacrylate/methacrylic acid copolymer (m : n = 95 : 5) in methyl cellosolve acetate. The thus-prepared coating solution was applied in accordance with the spin-coating method onto a chromium photomask substrate of 5" x 5" square, so as to form a resist film of about 5000 Å thick. The resulting resist-coated substrate was subjected to a pre-baking treatment in a nitrogen ambient, at 170°C and for 40 minutes, thereby obtaining Sample 1.

For comparison, resist films of polymethylmethacrylate and polytrifluoroethyl-α-chloroacrylate were respectively applied onto the same photomask substrates as that used above, each, to a thickness of 0.5 μm, thereby obtaining samples for Comparative Examples 1 and 2.

Each of these samples was irradiated by an electron beam at an accelerating voltage of 20 KV to form a latent image of a circuit pattern according to the data designed beforehand (radiation dose: 0.5 ∿ 100 $\mu C/cm^2$; pattern width (or Size): 0.1 ∿ 100 μm) and then developed with a 70 : 30 mixed solvent of methyl

isobutyl ketone and isopropyl alcohol to form a positive resist pattern. The width of the thus-formed resist pattern was thereafter measured using a laser reflection-type dimension measuring apparatus.

Next, each choromium layer was subjected to an etching treatment for 40 seconds in an acidic etchant consisting of the mixture of cerium ammonium-nitrate and perchloric acid, thereby forming a chromium mask pattern. The pattern width of chromium mask was measured in the same manner as above. Test results are summarized in Table 1.

Example 2

A resist-coated substrate was prepared and treated in the same manner as in Example 1 except that trifluoroethyl-α-chloroacrylate/α-chloroacrylic acid copolymer (m : n = 80 : 20) was used as the resist, thereby obtaining Sample 2.

Sample 2 was also subjected to the same steps for the measuring test as in Example 1. The results are shown together in Table 1.

Table 1

| | Electron beam sensitivity ($\mu C/cm^2$) | Resolution ($\mu m$) | Pattern width deviation ($\mu m$) | | | Uniformity of etching |
|---|---|---|---|---|---|---|
| | | | Designed width: 4μm | Designed width: 2μm | Designed width: 1μm | |
| Sample 1 | 1 | ≃ 0.2 | 0.02 | 0.03 | 0.03 | good |
| Sample 2 | 1.5 | ≃ 0.2 | 0.02 | 0.05 | 0.03 | good |
| Sample 3 | 1.3 | ≃ 0.2 | 0.02 | 0.03 | 0.03 | good |
| Comparative Example 1 | 30 | ≃ 0.1 | 0.02 | 0.02 | 0.03 | good |
| Comparative Example 2 | 1 | ≃ 0.2 | 0.08 | 0.10 | 0.12 | slightly poor |

Example 3

A resist consisting of trifluorobutyl-α-chloroacrylate/ methacrylic acid copolymer (m : n = 90 : 10) was employed as Sample 3. The processing of the resist was almost the same as in Example 1.

The pattern width of Sample 3 was measured before and after etching treatment by the same apparatus as in Example 1. The results are given also in Table 1.

As being apparent from the above table, the resists according to this invention are excellent positive resists which substantially satisfy such the requirements as sensitivity, resolution and adhesion and, compared with polymethylmethacrylate (Comparative Example 1) which shows highest resolution among all prior art positive resists, its sensitivity is as high as about 20 to 30 times and its resolution is comparable. When compared with a homopolymer of a halogen-containing acrylate (Comparative Example 2), its sensitivity and resolution are almost the same but, as clearly indicated by the values of pattern width deviations, the resists according to this invention have still better characteristics with respect to the adhesion to a substrate, and thereby the uniformity of etching.

As has been described above, the resists according to this invention have extremely superior characteristics in the formation of microcircuit patterns to conventionally known resists and can thus be advantageously employed in the fabrication of photomasks, semiconductor integrated circuits, etc.

Claims:

1. A radiation-sensitivity positive resists which comprises a copolymer represented by the following formula:

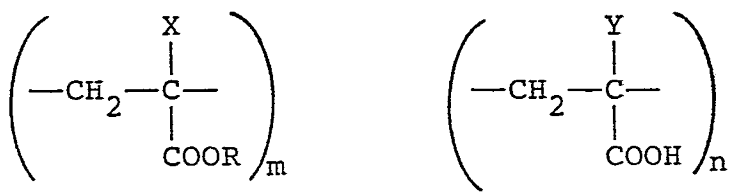

wherein X is a chlorine atom, a bromine atom or a fluorine atom; Y is a chlorine atom, a bromine atom, a fluorine atom or a methyl group; R is an alkyl group having 1 to 10 carbon atoms, at least one of the hydrogen of which alkyl group is substituted with a fluorine atom; and m and n are expressed in terms of mole % and are respectively $50 \leqq m \leqq 99.5$ and $0.5 \leqq n \leqq 50$.

2. The radiation-sensitive positive resist according to Claim 1, wherein said m and n are $80 \leqq m \leqq 99.5$ and $0.5 \leqq n \leqq 20$, respectively.

3. The radiation-sensitive positive resist according to Claim 1, wherein said X is a chlorine atom.

4. The radiation-sensitive positive resist according to Claim 3, which is trifluoroethyl-α-chloroacrylate/methacrylic acid compolymer of m : n = 95 : 5.

5. The radiation-sensitive positive resist according to Claim 3, which is trifluoroethyl-α-chloroacrylate/α-chloroacrylic acid copolymer of m : n = 80 : 20.

6. The radiation-sensitive positive resist according to Claim 3, which is trifluorobutyl-α-chloroacylate/methacrylic acid copolymer of m : n = 90 : 10.

European Patent Office

# EUROPEAN SEARCH REPORT

0076524
Application number

EP 82 10 9234

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X,Y D | US-A-4 259 407 (TADA et al./VLSI) * frontal page; abstract; column 1, line 58 to column 3, line 3; column 3, line 62 to column 4, line 20; column 4, lines 39-63; column 9, table 4; example 22 * | 1-6 | G 03 F 7/10 |
| Y | FR-A-2 299 665 (IBM) * claims 1-5; page 3, line 9 to page 4, line 36 * | 1-6 | |
| A | EP-A-0 006 938 (FUJITSU) * frontal page; abstract; page 4, lines 20-34 * | 1,6 | |
| P,A | EP-A-0 048 899 (SIEMENS) * frontal page; abstract; claims 1,2; page 6, lines 15-26 * | 1-6 | TECHNICAL FIELDS SEARCHED (Int. Cl. 3) |
| | | | G 03 F 7/00 |

The present search report has been drawn up for all claims

| Place of search | Date of completion of the search | Examiner |
|---|---|---|
| THE HAGUE | 05-01-1983 | DE ROY P.J.M. |

CATEGORY OF CITED DOCUMENTS

- X : particularly relevant if taken alone
- Y : particularly relevant if combined with another document of the same category
- A : technological background
- O : non-written disclosure
- P : intermediate document
- T : theory or principle underlying the invention
- E : earlier patent document, but published on, or after the filing date
- D : document cited in the application
- L : document cited for other reasons
- & : member of the same patent family, corresponding document

EPO Form 1503. 03.82